# EUROPEAN PATENT APPLICATION

(11) **EP 4 752 988 A1**
(43) Date of publication of application: **03.06.2026**
(21) Application number: 25217356.2
(22) Date of filing: 20.11.2025
(51) Int. Cl.: H01M 4/66

(54) **COMPOSITE SUBSTRATE FOR RECHARGEABLE LITHIUM BATTERY, METHOD FOR MANUFACTURING THE SAME, AND RECHARGEABLE LITHIUM BATTERY INCLUDING THE SAME**

(30) Priority: 26.11.2024 KR 20240170577
(71) Applicant: SAMSUNG SDI CO., LTD., Yongin-si, Gyeonggi-do 17084 (KR)
(72) Inventor: LEE, Wonhyung, 17084 Yongin-si, Gyeonggi-do (KR); KIM, Suhyun, 17084 Yongin-si, Gyeonggi-do (KR); CHA, Jungwook, 17084 Yongin-si, Gyeonggi-do (KR); KIM, Junyoung, 17084 Yongin-si, Gyeonggi-do (KR); KWON, Minseok, 17084 Yongin-si, Gyeonggi-do (KR)
(74) Representative: Bardehle Pagenberg Partnerschaft mbB Patentanwälte Rechtsanwälte

(57) **Abstract**

A composite substrate for a rechargeable lithium battery, a method for manufacturing the same, and a rechargeable lithium battery including the same are provided. The composite substrate may include a support layer including a polymer, a first metal layer on a first surface of the support layer, and a second metal layer on a second surface of the support layer, where at least one selected from among the first metal layer and the second metal layer may include a plurality of crystal grains, and an average grain size of the plurality of crystal grains may be about 50 nm to about 200 nm.

## Description

### CROSS-REFERENCE TO RELATED APPLICATIONS

The present application claims priority to and the benefit of Korean Patent Application No. 10-2024-0170577, filed on November 26, 2024, in the Korean Intellectual Property Office, the entire content of which is incorporated herein by reference.

### BACKGROUND

The present disclosure herein relates to a composite substrate for a rechargeable lithium battery, a method for manufacturing the composite substrate, and a rechargeable lithium battery including the composite substrate.

With the rapid proliferation of electronic devices, such as mobile phones, laptop computers, and/or electric vehicles, the demand for rechargeable batteries with high energy density and high capacity has significantly increased. As a result, extensive research and development efforts have been directed toward enhancing (e.g., improving) the performance of rechargeable lithium batteries.

A rechargeable lithium battery is a battery that includes a positive electrode and a negative electrode, including active materials capable of reversibly intercalating and deintercalating lithium ions, as well as an electrolyte. Electrical energy is generated through redox reactions that occur as lithium ions are intercalated into and deintercalated from the electrodes during charge and discharge cycles.

### SUMMARY

One or more aspects of the present disclosure are directed towards a composite substrate for a rechargeable lithium battery, having improved mechanical strength.

One or more other aspects of the present disclosure are directed towards a method for manufacturing a composite substrate for a rechargeable lithium battery, having improved mechanical strength.

One or more other aspects of the present disclosure are directed towards a rechargeable lithium battery including a composite substrate for a rechargeable lithium battery, having improved mechanical strength.

Additional aspects will be set forth in part in the description which follows and, in part, will be apparent from the description, or may be learned by practice of the presented embodiments of the disclosure.

In one or more embodiments of the present disclosure, a composite substrate may include a support layer including a polymer, a first metal layer on a first surface of the support layer, and a second metal layer on a second surface of the support layer. At least one selected from among the first metal layer and the second metal layer may include a plurality of crystal grains, and an average grain size of the plurality of crystal grains may be about 50 nm to about 200 nm. The composite substrate may be a composite substrate for a rechargeable lithium battery.

In one or more embodiments of the present disclosure, a rechargeable lithium battery may include a positive electrode, a negative electrode, and a separator between the positive electrode and the negative electrode. At least one selected from among the positive electrode and the negative electrode may include the composite substrate and an active material layer on the composite substrate.

In one or more embodiments of the present disclosure, a method may include performing plasma treatment on a support layer including a polymer, forming a plurality of protrusion structures on the surface of the support layer by repeatedly performing the plasma treatment n times, and performing a metal deposition process on the surface of the support layer to form a metal layer. n may be an integer between 6 and 15, and the method may be a method for manufacturing a composite substrate for a rechargeable lithium battery.

The composite substrate according to one or more embodiments of the present disclosure includes a suitable size of grains (e.g., particles) in the substrate that provides enhanced mechanical strength, so that curl may be prevented or reduced during the manufacturing process, thereby improving the efficiency of manufacturing a rechargeable lithium battery including such a composite substrate and the performance of the rechargeable lithium battery.

### BRIEF DESCRIPTION OF THE DRAWINGS

The accompanying drawings are included to provide a further understanding of the present disclosure, and are incorporated in and constitute a part of this specification. The drawings illustrate embodiments of the present disclosure and, together with the description, serve to explain principles of the present disclosure.
FIG. 1 is a simplified conceptual diagram showing a rechargeable lithium battery according to one or more embodiments of the present disclosure.
FIGS. 2 - 5 are schematic diagrams each showing rechargeable lithium batteries according to one or more embodiments.
FIG. 6 is a cross-sectional view for explaining a rechargeable lithium battery according to one or more embodiments of the present disclosure.
FIG. 7A is a cross-sectional view for explaining a composite substrate according to one or more embodiments of the present disclosure.
FIG. 7B is an enlarged cross-sectional view of area M in FIG. 7A.
FIG. 8A, FIG. 9A and FIG. 10A are cross-sectional views for explaining a method for manufacturing a composite substrate according to one or more embodiments of the present disclosure.
FIG. 8B, FIG. 9B and FIG. 10B are enlarged cross-sectional views showing areas M in FIG. 8A, FIG. 9A and FIG. 10A, respectively.

### DETAILED DESCRIPTION

Hereinafter, embodiments of the present disclosure will be described clearly and in more detail to such an extent that those skilled in the art easily implement the present disclosure. In order to sufficiently understand the configuration and effect of the present disclosure, one or more embodiments of the present disclosure will be described with reference to the accompanying drawings. It should be noted, however, that the present disclosure is not limited to the following example embodiments, and may be implemented in one or more suitable forms. Rather, the example embodiments are provided only to disclose the present disclosure and let those skilled in the art fully know the scope of the present disclosure.

In the present disclosure, it will be understood that, if (e.g., when) an element is referred to as being on another element, the element may be directly on the other element, or intervening elements may be present therebetween. In contrast, if (e.g., when) an element is referred to as being "directly on" another element, there are no intervening elements present. In the drawings, thicknesses of components are exaggerated for effectively explaining the technical contents. Like reference numerals or symbols refer to like elements throughout, and duplicative descriptions thereof may not be provided the specification.

In the present disclosure, if (e.g., when) a component (e.g., an element, an area, a layer, a part, a portion, a region, and/or the like) is referred to as being "on," formed on," "disposed on," "connected to," "connected with," or "coupled to" another component, the component may be directly formed on, formed on, disposed on, connected to, connected with, or coupled to the other component and/or indirectly on, formed on, disposed on, connected to, connected with, or coupled to the other component with an intervening component therebetween. For example, in the specification, if (e.g., when) a component is electrically connected to another component, the component may be directly electrically connected thereto and/or may be indirectly electrically connected thereto with an intervening component therebetween. However, "directly connected/directly coupled" refers to one component directly connecting or coupling another component without any intermediate component. Meanwhile, other expressions describing relationships between components such as "between," "immediately between" or "adjacent to" and "directly adjacent to" may be construed similarly. In addition, it will also be understood that when an element or layer is referred to as being "between" two elements or layers, it can be the only element or layer between the two elements or layers, or one or more intervening elements or layers may also be present.

In the drawings, thicknesses of some components are exaggerated for effectively explaining the technical contents. Like reference numerals refer to like elements throughout, and duplicative descriptions thereof may not be provided the specification.

Unless otherwise specially noted in the description, the expression of singular form (e.g., "a," "an," and/or "the") may include the expression of plural form, including "at least one," unless the context clearly dictates otherwise. In addition, unless otherwise specially noted, the phrase "A or B" may indicate "A but not B", "B but not A", and "A and B." The terms "comprise/include/have", "comprises/includes/has", and/or "comprising/including/having" utilized in this description, are intended to designate the presence of an embodied aspect, number, step (e.g., act or task), element, and/or a (e.g., any suitable) combination thereof, and do not preclude or exclude the presence or addition of one or more other features, numbers, steps (e.g., acts or tasks), elements, components, and/or a (e.g., any suitable) combination thereof. Additionally, the terms "comprise(s)/comprising," "include(s)/including," "have/has/having", or other similar terms include or support the terms "consisting of" and "consisting essentially of," indicating the presence of stated features, integers, steps, operations, elements, and/or components, without or essentially without the presence of other features, integers, steps, operations, elements, components, and/or groups thereof.

In one or more embodiments, the term "layer" herein includes not only a shape formed on the whole surface if (e.g., when) viewed from a plan view, but also a shape formed on a partial surface.

It will be understood that, although the terms "first," "second," "third," and/or the like may be utilized herein to describe one or more suitable elements, components, regions, layers and/or sections, these elements, components, regions, layers and/or sections should not be limited by these terms. These terms are only utilized to distinguish one element, component, region, layer or section from another element, component, region, layer, or section. Thus, a first element, component, region, layer, or section described herein may be termed a second element, component, region, layer or section without departing from the teachings set forth herein.

As utilized herein, the term "and/or" includes any, and all, combinations of one or more of the associated listed items. Expressions such as "at least one of," "one of," and "selected from," if (e.g., when) preceding a list of elements, modify the entire list of elements and do not modify the individual elements of the list. For example, the expressions "at least one of a to c," "at least one of a, b or c," and "at least one of a, b and/or c" may indicate only a, only b, only c, both (e.g., simultaneously) a and b, both (e.g., simultaneously) a and c, both (e.g., simultaneously) b and c, all of a, b, and c, or variations thereof.

Spatially relative terms, such as "beneath," "below," "lower," "above," "upper" and/or the like, may be utilized herein to easily describe the relationship between one element or feature and another element or feature. It will be understood that the spatially relative terms are intended to encompass different orientations of a device in utilization or operation in addition to the orientation illustrated in the drawings. For example, if (e.g., when) the device in the drawings is turned over, elements described as "below" or "beneath" other elements or features will be oriented "above" the other elements or features. Thus, the example term "below" can encompass both (e.g., simultaneously) the orientations of above and below. The device may be otherwise oriented (rotated 90 degrees or at other orientations), and the spatially relative terms utilized herein may be interpreted accordingly.

The terminology utilized herein is utilized for the purpose of describing particular embodiments only, and is not intended to limit the present disclosure. Unless otherwise defined, all terms (including chemical, technical and scientific terms) utilized herein have the same meaning as commonly understood by one of ordinary skill in the art to which this disclosure pertains. It will be further understood that terms, such as those defined in commonly utilized dictionaries, should be interpreted as having a meaning that is consistent with their meaning in the context of the related art and the present disclosure, and will not be interpreted in an idealized or overly formal sense.

Example embodiments are described herein with reference to cross-sectional views, which are schematic views of idealized embodiments. As such, variations from the shapes of the illustrations as a result, for example, of manufacturing techniques and/or tolerances, are to be expected. Thus, embodiments described herein should not be construed as being limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the drawings are schematic in nature and their shapes are not intended to illustrate the precise shape of a region and are not intended to limit the scope of the present claims.

The term "may" will be understood to refer to "one or more embodiments of the present disclosure," some of which include the described element and some of which exclude that element and/or include an alternate element. Similarly, alternative language such as "or" refers to "one or more embodiments of the present disclosure," each including a corresponding listed item.

In this context, "consisting essentially of" indicates that any additional components will not materially affect the chemical, physical, optical or electrical properties of the semiconductor film.

Further, in this specification, the phrase "on a plane," or "plan view," indicates viewing a target portion from the top, and the phrase "on a cross-section" indicates viewing a cross-section formed by vertically cutting a target portion from the side.

In the present disclosure, the term "combination thereof" may refer to a mixture, a stack, a composite, a copolymer, an alloy, a blend, and/or a reaction product.

The term "particle diameter", "particle size", and/or the like as utilized herein refers to an average diameter of particles if (e.g., when) the particles are spherical, and refers to an average major axis length of particles if (e.g., when) the particles are non-spherical. For example, a particle diameter may be an average particle diameter. In some embodiments, a particle diameter indicates an average particle diameter (D₅₀) where a cumulative volume is about 50 volume % in a particle size distribution. The average particle diameter (D₅₀) may be measured by a method widely suitable to those skilled in the art, for example, by a particle size analyzer, a transmission electron microscope (TEM) image, or a scanning electron microscope (SEM) image. In one or more embodiments, a dynamic light-scattering measurement device is used to perform a data analysis, the number of particles is counted for each particle size range, and then from this, an average particle diameter (D₅₀) value may be obtained through a calculation. Dissimilarly, a laser scattering method may be utilized to measure the average particle diameter (D₅₀). In the laser scattering method, a target particle is distributed in a dispersion solvent, introduced into a laser scattering particle measurement device (e.g., MT3000 commercially available from Microtrac, Inc), irradiated with ultrasonic waves of 28 kHz at a power of 60 W, and then an average particle diameter (D₅₀) is calculated in the 50% standard of particle diameter distribution in the measurement device.

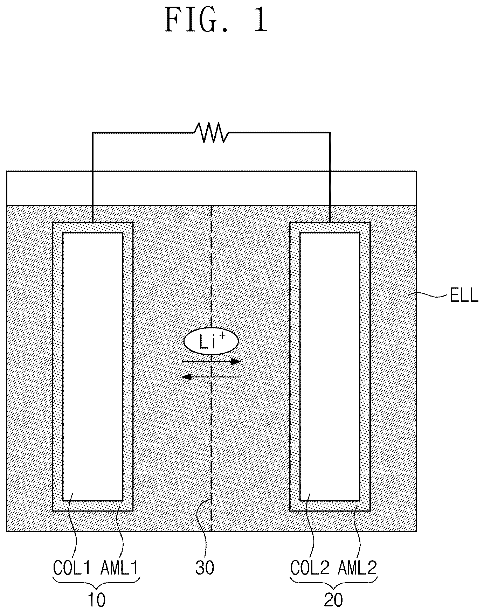

FIG. 1 is a conceptual diagram schematically illustrating a rechargeable lithium battery according to one or more embodiments of the present disclosure. Referring to FIG. 1, the rechargeable lithium battery may include a positive electrode 10, a negative electrode 20, a separator 30, and an electrolyte ELL.

The positive electrode 10 and the negative electrode 20 may be spaced and/or apart (e.g., spaced apart or separated) from each other with the separator 30 therebetween. The separator 30 may be arranged between the positive electrode 10 and the negative electrode 20. The positive electrode 10, the negative electrode 20, and the separator 30 may be in contact with the electrolyte ELL. The positive electrode 10, the negative electrode 20, and the separator 30 may be impregnated in the electrolyte ELL.

The electrolyte ELL may be a medium transferring lithium ions between the positive electrode 10 and the negative electrode 20. In the electrolyte ELL, the lithium ions may pass through the separator 30 and move toward the positive electrode 10 or the negative electrode 20.

### Positive Electrode 10

The positive electrode 10 for a rechargeable lithium battery may include a current collector COL1 and a positive electrode active material layer AML1 on (e.g., formed on) the current collector COL1. The positive electrode active material layer AML1 may include a positive electrode active material and may further include a binder and/or a conductive material (e.g., electron conductor).

For example, the positive electrode 10 may further include an additive that may function as a sacrificial positive electrode.

The content (e.g., amount) of the positive electrode active material in the positive electrode active material layer AML1 may be about 90 wt% to about 99.5 wt% based on a total weight (100 wt%) of the positive electrode active material layer AML1. The content (e.g., amount) of the binder and the conductive material may each be about 0.5 wt% to about 5 wt% based on 100 wt% of the positive electrode active material layer AML1.

The binder serves to attach positive electrode active material particles well to each other and also to attach the positive electrode active material well to the current collector COL1. In one or more embodiments, examples of the binder may include polyvinyl alcohol, carboxymethyl cellulose, hydroxypropyl cellulose, diacetyl cellulose, polyvinyl chloride, carboxylated polyvinyl chloride, polyvinyl fluoride, polymers containing ethylene oxide, polyvinyl pyrrolidone, polyurethane, polytetrafluoroethylene, polyvinylidene fluoride, polyethylene, polypropylene, styrene-butadiene rubber, (meth)acrylated styrene-butadiene rubber, an epoxy resin, a (meth)acrylic resin, a polyester resin, nylon, and/or the like, but the present disclosure is not limited thereto.

The conductive material may be utilized to provide conductivity to an electrode, and any electronically conductive material that does not cause a chemical change in the configured battery (e.g., causing minimum chemical change) may be utilized. In one or more embodiments, examples of the conductive material may include carbon-based materials such as natural graphite, artificial graphite, carbon black, acetylene black, Ketjen black, carbon fibers, carbon nanofibers, and/or carbon nanotubes; metal-based materials including copper, nickel, aluminum, silver, and/or the like and in the form of metal powder or metal fibers; conductive polymers such as polyphenylene derivatives; and/or a mixture thereof.

Al may be utilized as the current collector COL1, but the present disclosure is not limited thereto.

### Positive Electrode Active Material

A compound capable of reversible intercalation and deintercalation of lithium (lithiated intercalation compound) may be utilized as the positive electrode active material in the positive electrode active material layer AML1. For example, one or more composite oxides of lithium and a metal selected from among cobalt, manganese, nickel, and a (e.g., any suitable) combination thereof may be utilized.

The composite oxide may be a lithium transition metal composite oxide, and examples of the lithium transition metal composite oxide may include lithium nickel-based oxides, lithium cobalt-based oxides, lithium manganese-based oxides, lithium iron phosphate-based compounds, cobalt-free nickel-manganese-based oxides, and/or a (e.g., any suitable) combination thereof.

In one or more embodiments, a compound represented by at least one of (e.g., at least one selected from among) the chemical formulas may be utilized. LiₐA_{1-b}X_{b}O_{2-c}D_{c} (0.90≤a≤1.8, 0≤b≤0.5, 0≤c≤0.05); LiₐMn_{2-b}X_{b}O_{4-c}D_{c} (0.90≤a≤1.8, 0≤b≤0.5, 0≤c≤0.05); LiₐNi_{1-b-c}Co_{b}X_{c}O_{2-α}D_{α} (0.90≤a≤1.8, 0≤b≤0.5, 0≤c≤0.5, 0<α<2); LiₐNi_{1-b-c}Mn_{b}X_{c}O_{2-α}D_{α} (0.90≤a≤1.8, 0≤b≤0.5, 0≤c≤0.5, 0<α<2); LiₐNi_{b}Co_{c}L¹_{d}GₑO₂ (0.90≤a≤1.8, 0≤b≤0.9, 0≤c≤0.5, 0≤d≤0.5, 0≤e≤0.1); LiₐNiG_{b}O₂ (0.90≤a≤1.8, 0.001≤b≤0.1); LiₐCoG_{b}O₂ (0.90≤a≤1.8, 0.001≤b≤0.1); LiₐMn_{1-b}G_{b}O₂ (0.90≤a≤1.8, 0.001≤b≤0.1); LiₐMn₂G_{b}O₄ (0.90≤a≤1.8, 0.001≤b≤0.1); LiₐMn_{1-g}G_{g}PO₄ (0.90≤a≤1.8, 0≤g≤0.5); Li_{(3-f)}Fe₂(PO₄)₃ (0≤f≤2); and/or LiₐFePO₄ (0.90≤a≤1.8).

In the chemical formulas, A may be Ni, Co, Mn, and/or a (e.g., any suitable) combination thereof; X may be Al, Ni, Co, Mn, Cr, Fe, Mg, Sr, V, rare earth elements, and/or a (e.g., any suitable) combination thereof; D may be O, F, S, P, and/or a (e.g., any suitable) combination thereof; G may be Al, Cr, Mn, Fe, Mg, La, Ce, Sr, V, and/or a (e.g., any suitable) combination thereof; and L¹ may be Mn, Al, and/or a (e.g., any suitable) combination thereof.

For example, the positive electrode active material may be a high-nickel-based positive electrode active material in which the nickel content (e.g., amount) is about 80 mol% or more, about 85 mol% or more, about 90 mol% or more, about 91 mol% or more, or about 94 mol% or more and about 99 mol% or less, based on a total number of moles (100 mol%) of metals excluding lithium in the lithium transition metal composite oxide. The high-nickel-based positive electrode active material may achieve high capacity and thus may be applied to high-capacity, high-density rechargeable lithium batteries.

### Negative Electrode 20

The negative electrode 20 for a rechargeable lithium battery may include a current collector COL2, and a negative electrode active material layer AML2 on (e.g., positioned on) the current collector COL2. The negative electrode active material layer AML2 may include a negative electrode active material, and may further include a binder and/or a conductive material (e.g., electron conductor).

For example, the negative electrode active material layer AML2 may include about 90 wt% to about 99 wt% of a negative electrode active material, about 0.5 wt% to about 5 wt% of a binder, and about 0 wt% to about 5 wt% of a conductive material based on 100 wt% of the negative electrode active material layer AML2.

The binder serves to attach negative electrode active material particles well to each other, and also to attach the negative electrode active material well to the current collector COL2. The binder may be a non-aqueous binder, an aqueous binder, a dry binder, and/or a (e.g., any suitable) combination thereof.

The non-aqueous binder may include polyvinyl chloride, carboxylated polyvinyl chloride, polyvinyl fluoride, an ethylene propylene copolymer, polystyrene, polyurethane, polytetrafluoroethylene, polyvinylidene fluoride, polyethylene, polypropylene, polyamideimide, polyimide, and/or a (e.g., any suitable) combination thereof.

The aqueous binder may be selected from among styrene-butadiene rubber, (meth)acrylated styrene-butadiene rubber, (meth)acrylonitrile-butadiene rubber, (meth)acrylic rubber, butyl rubber, fluoroelastomer, polyethylene oxide, polyvinylpyrrolidone, polyepichlorohydrin, polyphosphazene, poly(meth)acrylonitrile, an ethylene propylene diene copolymer, polyvinylpyridine, chlorosulfonated polyethylene, latex, a polyester resin, a (meth)acrylic resin, a phenol resin, an epoxy resin, polyvinyl alcohol, and a (e.g., any suitable) combination thereof.

If (e.g., when) the aqueous binder is utilized as the negative electrode binder, a cellulose series compound capable of imparting viscosity may be further included. The cellulose series compound may be utilized by mixing one or more selected from among carboxymethyl cellulose, hydroxypropyl methylcellulose, methyl cellulose, and an alkali metal salt thereof. The alkali metal may be selected from among Na, K, and Li.

The dry binder may be a polymer material capable of fiberization, for example, polytetrafluoroethylene, polyvinylidene fluoride, a polyvinylidene fluoride-hexafluoropropylene copolymer, polyethylene oxide, and/or a (e.g., any suitable) combination thereof.

The conductive material is utilized to provide conductivity to the electrode, and any material that does not cause a chemical change and is electronically conductive may be utilized in the battery to be formed. Specific examples include carbon-based materials such as natural graphite, artificial graphite, carbon black, acetylene black, Ketjen black, carbon fibers, carbon nanofibers, and carbon nanotubes; metal-based materials containing copper, nickel, aluminum, silver and/or the like and in the form of metal powder or metal fiber; conductive polymers such as polyphenylene derivatives; or a mixture thereof.

The current collector COL2 may be selected from among copper foil, nickel foil, stainless steel foil, titanium foil, nickel foam, copper foam, polymer substrate coated with a conductive metal, and a (e.g., any suitable) combination thereof.

### Negative Electrode Active Material

The negative electrode active material in the negative electrode active material layer AML2 may include a material capable of reversibly intercalating/deintercalating lithium ions, a lithium metal, an alloy of lithium metal, a material capable of doping and dedoping lithium, and/or a transition metal oxide.

The material capable of reversibly intercalating/deintercalating lithium ions may include a carbon-based negative electrode active material, for example, crystalline carbon, amorphous carbon, and/or a (e.g., any suitable) combination thereof. In one or more embodiments, examples of crystalline carbon may include graphite such as amorphous, plate-like, flake-like, spherical, or fiber-like natural graphite or artificial graphite, and examples of the amorphous carbon may include soft carbon or hard carbon, mesophase pitch carbide, calcined coke, and/or the like.

In one or more embodiments, the alloy of lithium metal may include an alloy of lithium and a metal selected from among Na, K, Rb, Cs, Fr, Be, Mg, Ca, Sr, Si, Sb, Pb, In, Zn, Ba, Ra, Ge, Al, and Sn.

In one or more embodiments, the material capable of doping and dedoping lithium may include a Si-based negative electrode active material and/or a Sn-based negative electrode active material. The Si-based negative electrode active material may be silicon, a silicon-carbon composite, SiOx (0<x≤2, e.g., SiO₂), a Si-Q alloy (where Q may be selected from among an alkali metal, an alkaline earth metal, a Group 13 element, a Group 14 element (excluding Si), a Group 15 element, a Group 16 element, a transition metal, a rare earth element, and/or a (e.g., any suitable) combination thereof), and/or a (e.g., any suitable) combination thereof. The Sn-based negative electrode active material may be Sn, SnO₂, a Sn-based alloy, and/or a (e.g., any suitable) combination thereof.

The silicon-carbon composite may be a composite of silicon and amorphous carbon. According to one or more embodiments, the silicon-carbon composite may be in the form of silicon particles and amorphous carbon coated on the surface of the silicon particles. For example, a secondary particle (core) in which silicon primary particles are assembled and an amorphous carbon coating layer (shell) positioned on the surface of the secondary particle may be included. The amorphous carbon may also be positioned between the silicon primary particles, so that, for example, the silicon primary particles may be coated with amorphous carbon. The secondary particles may be dispersed and present in an amorphous carbon matrix.

The silicon-carbon composite may further include crystalline carbon. For example, the silicon-carbon composite may include a core including crystalline carbon and silicon particles and an amorphous carbon coating layer on (e.g., positioned on) the surface of the core.

The Si-based negative electrode active material and/or the Sn-based negative electrode active material may be utilized in combination with a carbon-based negative electrode active material.

### Separator 30

Depending on the type (kind) of rechargeable lithium battery, a separator 30 may be present between the positive electrode 10 and the negative electrode 20. In one or more embodiments, the separator 30 may be polyethylene, polypropylene, polyvinylidene fluoride, and/or a multilayer of two or more thereof. The multilayer of two or more selected from among polyethylene, polypropylene, polyvinylidene fluoride (e.g., a mixed multilayer) may be a polyethylene/polypropylene two-layer separator, a polyethylene/polypropylene/polyethylene three-layer separator, and/or a polypropylene/polyethylene/polypropylene three-layer separator.

The separator 30 may include a porous substrate and/or a coating layer including an organic material, an inorganic material, and/or a (e.g., any suitable) combination thereof positioned on one or both (e.g., simultaneously) sides (e.g., opposite sides) of the porous substrate.

The porous substrate may be a polymer film formed of at least one polymer selected from among polyolefins such as polyethylene and polypropylene, polyesters such as polyethylene terephthalate and polybutylene terephthalate, polyacetal, polyamide, polyimide, polycarbonate, polyether ketone, polyarylether ketone, polyetherimide, polyamideimide, polybenzimidazole, polyether sulfone, polyphenylene oxide, cyclic olefin copolymer, polyphenylene sulfide, polyethylene naphthalate, glass fiber, and polytetrafluoroethylene (e.g., TEFLON), and/ort a copolymer or mixture of two or more thereof.

The organic material may include a polyvinylidene fluoride-based polymer and/or a (meth)acrylic polymer.

The inorganic material may include inorganic particles selected from among Al₂O₃, SiO₂, TiO₂, SnO₂, CeO₂, MgO, NiO, CaO, GaO, ZnO, ZrO₂, Y₂O₃, SrTiO₃, BaTiO₃, Mg(OH)₂, boehmite, and a (e.g., any suitable) combination thereof, but the present disclosure is not limited thereto.

The organic material and inorganic material may be mixed and present in one coating layer, or may exist in a form in which a coating layer including an organic material and a coating layer including an inorganic material may be laminated.

### Electrolyte ELL

The electrolyte ELL for a rechargeable lithium battery may include a non-aqueous organic solvent and a lithium salt.

The non-aqueous organic solvent may act as a medium through which ions involved in the electrochemical reaction of the battery may move.

The non-aqueous organic solvent may be a carbonate-based, ester-based, ether-based, ketone-based, or alcohol-based solvent, an aprotic solvent, and/or a (e.g., any suitable) combination thereof.

In one or more embodiments, the carbonate-based solvent may be dimethyl carbonate (DMC), diethyl carbonate (DEC), dipropyl carbonate (DPC), methyl propyl carbonate (MPC), ethyl propyl carbonate (EPC), methyl ethyl carbonate (MEC), ethylene carbonate (EC), propylene carbonate (PC), butylene carbonate (BC), and/or the like.

In one or more embodiments, the ester-based solvent may be methyl acetate, ethyl acetate, n-propyl acetate, dimethyl acetate, methyl propionate, ethyl propionate, decanolide, mevalonolactone, valerolactone, caprolactone, and/or the like.

In one or more embodiments, the ether-based solvent may be dibutyl ether, tetraglyme, diglyme, dimethoxyethane, 2-methyltetrahydrofuran, 2,5-dimethyltetrahydrofuran, tetrahydrofuran, and/or the like. In addition, the ketone-based solvent may be cyclohexanone and/or the like. The alcohol-based solvent may be ethyl alcohol, isopropyl alcohol, and/or the like. The aprotic solvent may be nitriles such as R-CN (where R may be a linear, branched, or cyclic hydrocarbon group having 2 to 20 carbon atoms and may include a double bond, an aromatic ring, or an ether group); amides such as dimethylformamide; dioxolanes such as 1,3-dioxolane and/or 1,4-dioxolane; sulfolanes; and/or the like.

The non-aqueous organic solvent may be utilized alone or in combination of two or more.

In addition, if (e.g., when) a carbonate-based solvent is utilized, a cyclic carbonate and a chain carbonate may be mixed and utilized, and the cyclic carbonate and the chain carbonate may be mixed in a volume ratio of about 1:1 to about 1:9.

The lithium salt may be a substance that may be dissolved in an organic solvent and act as a source of lithium ions within a battery, enabling the basic operation of a rechargeable lithium battery and promoting the movement of lithium ions between positive and negative electrodes. In one or more embodiments, examples of the lithium salt may include one or more (e.g., two) selected from among LiPF₆, LiBF₄, LiSbF₆, LiAsF₆, LiClO₄, LiAlO₂, LiAlCl₄, LiPO₂F₂, LiCl, Lil, LiN(SO₃C₂F₅)₂, Li(FSO₂)₂N (lithium bis(fluorosulfonyl)imide (LiFSI), LiC₄F₉SO₃, LiN(CₓF₂ₓ₊₁SO₂)(C_{y}F_{2y+1}SO₂) (x and y are integers from 1 to 20), lithium trifluoromethane sulfonate, lithium tetrafluoroethanesulfonate, lithium difluorobis(oxalato)phosphate (LiDFOB), and lithium bis(oxalato)borate (LiBOB).

### Rechargeable Lithium Battery

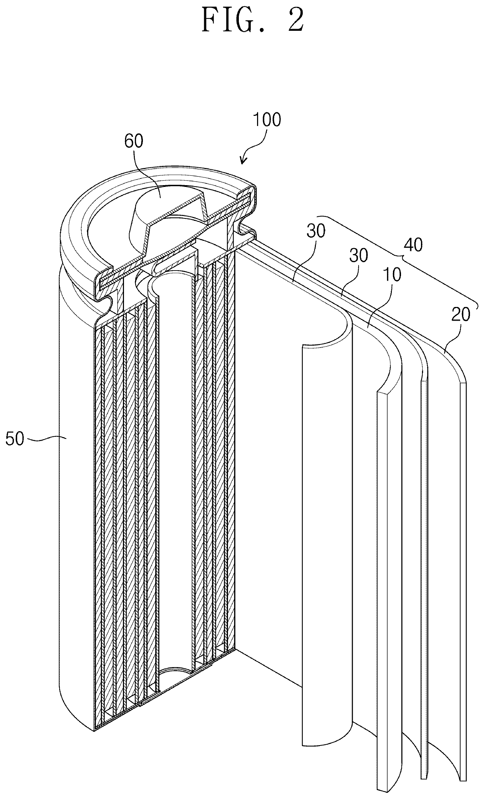

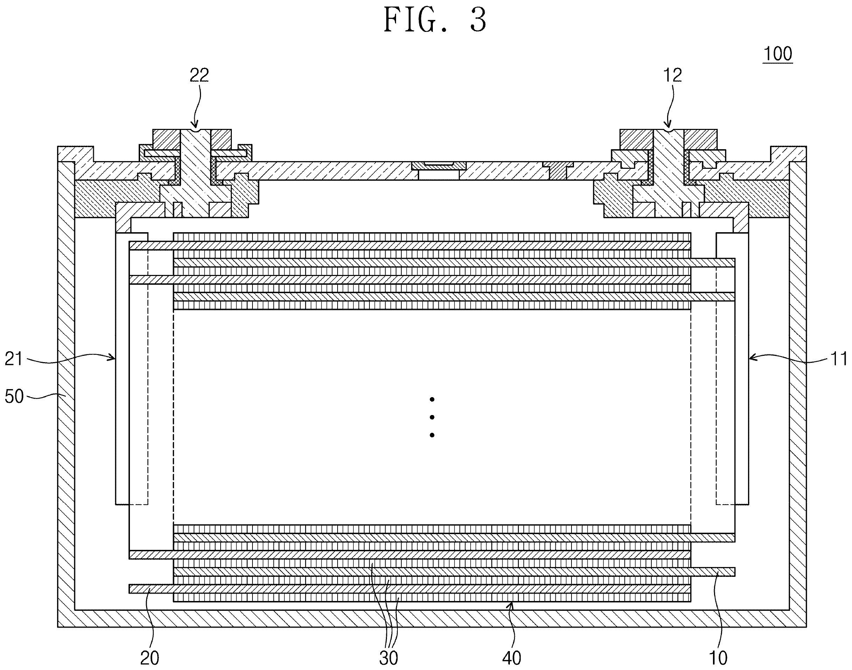

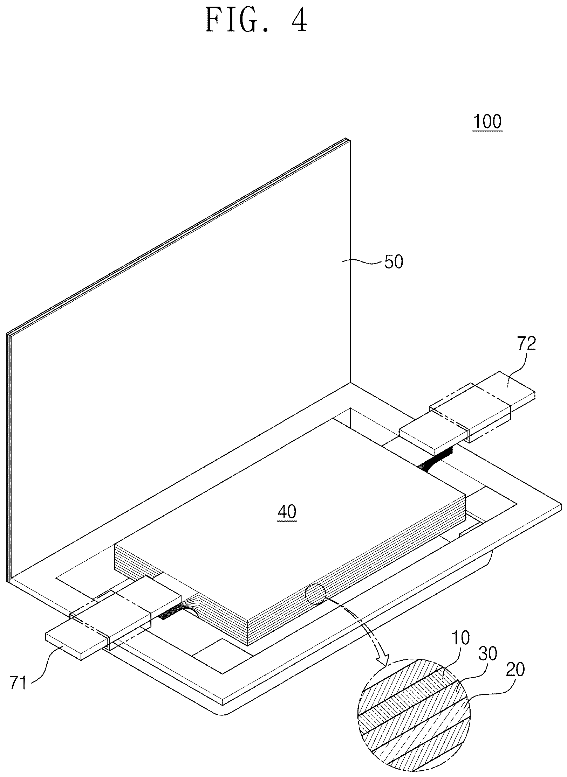

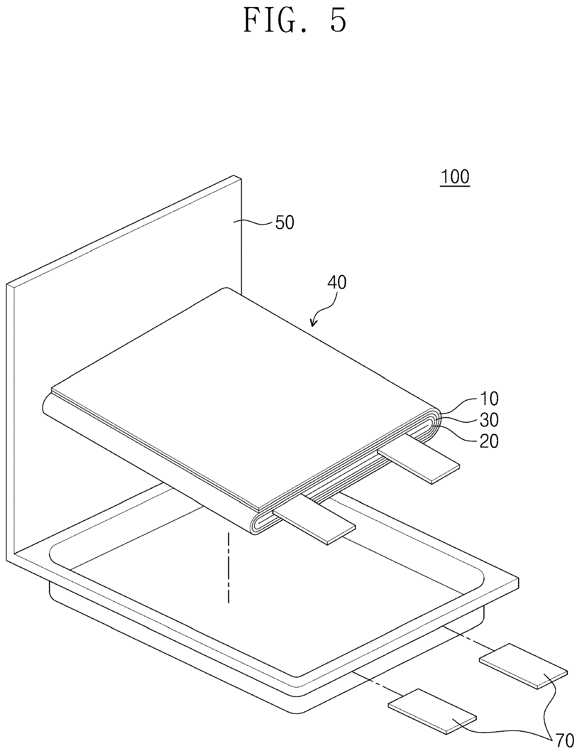

Rechargeable lithium batteries may be classified into cylindrical, prismatic, pouch, and coin types (kinds) according to the shape. FIG. 2 to FIG. 5 are schematic diagrams each illustrating rechargeable lithium batteries according to one or more embodiments, where FIG. 2 may be a cylindrical battery, FIG. 3 may be a prismatic battery, and FIGS. 4 and 5 may be pouch-type (kind) batteries. Referring to FIGS. 2 to 4, a rechargeable lithium battery 100 may include an electrode assembly 40 having a separator 30 between (e.g., interposed between) a positive electrode 10 and a negative electrode 20, and a case 50 in which the electrode assembly 40 may be accommodated. The positive electrode 10, the negative electrode 20, and the separator 30 may be impregnated with an electrolyte. The rechargeable lithium battery 100 may include a sealing member 60 that may seal the case 50 as in FIG. 2. In addition, in FIG. 3, the rechargeable lithium battery 100 may include a positive electrode lead tab 11, a positive electrode terminal 12, a negative electrode lead tab 21, and a negative electrode terminal 22. As shown in FIG. 4 and FIG. 5, the rechargeable lithium battery 100 may include electrode tabs 70, for example, a positive electrode tab 71 and a negative electrode tab 72, which may serve as electrical paths for inducing the current formed in the electrode assembly 40 to the outside.

In one or more embodiments of the present disclosure described, a detailed description of technical features overlapping with the rechargeable lithium battery described with reference to FIGS. 1 to 5 will not be provided, and differences will be described in more detail.

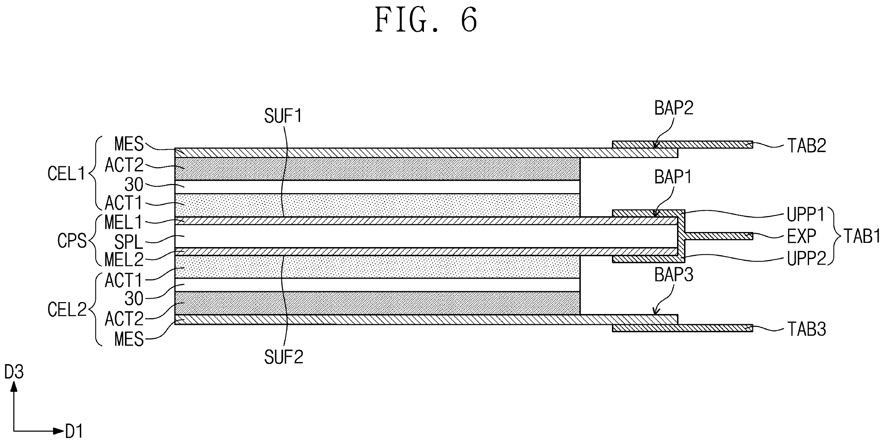

FIG. 6 is a cross-sectional view for explaining a rechargeable lithium battery according to one or more embodiments of the present disclosure. Referring to FIG. 6, a composite substrate CPS, a first battery cell CEL1 on the first surface SUF1 of the composite substrate CPS, and a second battery cell CEL2 on the second surface SUF2 of the composite substrate CPS may be provided. The first surface SUF1 and the second surface SUF2 may face each other in a third direction (D3).

The first battery cell CEL1, the second battery cell CEL2, and the composite substrate CPS in FIG. 6 may form one bicell. The first battery cell CEL1, the second battery cell CEL2, and the composite substrate CPS in FIG. 6 may form an electrode assembly 40 described above with reference to FIGS. 3 to 5.

Each of the first battery cell CEL1 and the second battery cell CEL2 may include a first active material layer ACT1, a separator 30, a second active material layer ACT2, and a metal substrate MES. The first active material layer ACT1 may be provided on the composite substrate CPS. The second active material layer ACT2 may be spaced and/or apart (e.g., spaced apart or separated) from the first active material layer ACT1 with the separator 30 arranged therebetween. The metal substrate MES may be provided on the second active material layer ACT2.

The first active material layer ACT1 may be one selected from among the positive electrode active material layer AML1 and the negative electrode active material layer AML2, described above with reference to FIG. 1. The second active material layer ACT2 may be another one selected from among the positive electrode active material layer AML1 and the negative electrode active material layer AML2 described above with reference to FIG. 1. In one or more embodiments of the present disclosure, the first active material layer ACT1 may be the positive electrode active material layer AML1, and the second active material layer ACT2 may be the negative electrode active material layer AML2. The metal substrate MES may be the current collector COL1 or COL2 described above with reference to FIG. 1.

The composite substrate CPS may include a support layer SPL, and a first metal layer MEL1 and a second metal layer MEL2 provided on both sides (e.g., opposite sides) of the support layer SPL, respectively. For example, the first metal layer MEL1 and the second metal layer (MEL2) are arranged on opposite sides of the support layer SPL, respectively. The composite substrate CPS may include a first bare part BAP1 at one end thereof. The metal substrate MES of the first battery cell CEL1 may include a second bare part BAP2 at one end thereof. The metal substrate MES of the second battery cell CEL2 may include a third bare part BAP3 at one end thereof.

A first tab TAB1 may be connected to the first bare part BAP1 of the composite substrate CPS. The first tab TAB1 may include a first connection part UPP1, a second connection part UPP2, and an extension part EXP. The first connection part UPP1 may be in contact with the first metal layer MEL1 of the composite substrate CPS. The second connection part UPP2 may be in contact with the second metal layer MEL2 of the composite substrate CPS. The extension part EXP may connect the first connection part UPP1 and the second connection part UPP2 to each other. The extension part EXP may be to extend horizontally from the first bare part BAP1 toward a first direction D1.

The first metal layer MEL1 and the second metal layer MEL2 of the composite substrate CPS may be electrically connected to each other by the first tab TAB1. The first tab TAB1 may be commonly to apply a voltage to the first metal layer MEL1 and the second metal layer MEL2 of the composite substrate CPS.

The second tab TAB2 may be connected to the second bare part BAP2 of the metal substrate MES. The second tab TAB2 may be to apply a voltage to the metal substrate MES of the first battery cell CEL1. A third tab TAB3 may be connected to the third bare part BAP3 of the metal substrate MES. The third tab TAB3 may apply a voltage to the metal substrate MES of the second battery cell CEL2.

The first tab TAB1 may configure one selected from among the positive electrode tab (or positive electrode lead tab) and the negative electrode tab (or negative electrode lead tab) described above with reference to FIGS. 2 to 4. The second and third tabs TAB2 and TAB3 may configure the other selected from among the positive electrode tab (or positive electrode lead tab) and the negative electrode tab (or negative electrode lead tab) described above with reference to FIGS. 2 to 4.

The first metal layer MEL1 of the composite substrate CPS may be in contact with the first active material layer ACT1 of the first battery cell CEL1. The second metal layer MEL2 of the composite substrate CPS may be in contact with the first active material layer ACT1 of the second battery cell CEL2. Each of the first and second metal layers MEL1 and MEL2 of the composite substrate CPS may correspond to the current collector COL1 or COL2 described above with reference to FIG. 1.

Each of the first and second metal layers MEL1 and MEL2 may include at least one selected from among aluminum, an aluminum alloy, copper, a copper alloy, nickel, a nickel alloy, titanium, a titanium alloy, iron, an iron alloy, silver, and a silver alloy.

The support layer SPL may include a polymer film. For example, the support layer SPL may include a polyethylene film, a polypropylene film, a polyvinylidene chloride film, and/or a multilayer film of a (e.g., any suitable) combination thereof. The support layer SPL may have excellent or suitable ion permeability and excellent or suitable mechanical strength.

In one or more embodiments of the present disclosure, each of the first and second metal layers MEL1 and MEL2 may have a thickness of about 200 nm to about 5 µm. The support layer SPL may have a thickness of about 3 µm to about 10 µm. The thickness of the support layer SPL may be greater than the thickness of each of the first and second metal layers MEL1 and MEL2.

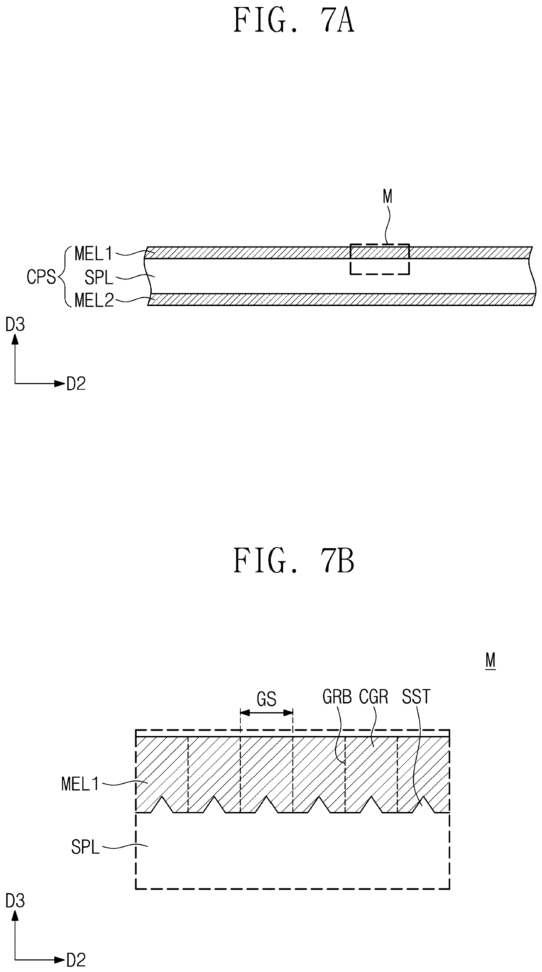

FIG. 7A is a cross-sectional view for explaining a composite substrate according to one or more embodiments of the present disclosure. FIG. 7B is an enlarged cross-sectional view of area M in FIG. 7A.

Referring to FIGS. 7A and 7B, the composite substrate CPS may include a support layer SPL, and a first metal layer MEL1 and a second metal layer MEL2 provided on both sides (e.g., opposite sides) of the support layer SPL, respectively. The support layer SPL, the first metal layer MEL1, and the second metal layer MEL2 may be substantially the same as that described above with reference to FIG. 6.

Referring again to FIG. 7B, the support layer SPL according to one or more embodiments of the present disclosure may include a plurality of protrusion structures SST on the surface thereof. Each of the protrusion structures SST may be a microstructure on (e.g., formed on) the surface of the support layer SPL. The average size of the protrusion structures SST may be about 50 nm to about 200 nm. For example, the maximum average width of the protrusion structures SST in the second direction D2 may be about 50 nm to about 200 nm.

The plurality of protrusion structures SST may be formed by plasma treatment performed on the surface of the support layer SPL. For example, each of the plurality of protrusion structures SST may have a pointed conical protrusion shape. Each of the plurality of protrusion structures SST may have a three-dimensional structure. The plurality of protrusion structures SST may be two-dimensionally arranged along the first direction D1 and the second direction D2 on the surface of the support layer SPL.

The first metal layer MEL1 may be provided on the surface of the support layer SPL. For example, the first metal layer MEL1 may be provided on the plurality of protrusion structures SST of the support layer SPL.

The first metal layer MEL1 may include a plurality of crystal grains CGR (e.g., be in a form of the plurality of crystal grains CGR). In one or more embodiments, the plurality of crystal grains CGR may be provided on the plurality of protrusion structures SST, respectively. Each of the crystal grains CGR may be formed by depositing metal on the protrusion structure SST during a deposition process.

A grain boundary GRB may exist between adjacent crystal grains CGR. The grain boundary GRB may be positioned between adjacent protrusion structures SST. For example, the grain boundary GRB may be extended in a direction normal (e.g., perpendicular) to the first surface SUF1.

In one or more embodiments of the present disclosure, the crystal grains CGR and the grain boundaries GRB in the first metal layer MEL1 may be confirmed through electron microscopy on the first metal layer MEL1. For example, the crystal grains CGR and the grain boundaries GRB may be confirmed through scanning electron microscope (SEM) analysis or transmission electron microscope (TEM) analysis of the first metal layer MEL1.

In one or more other embodiment of the present disclosure, the crystal grains CGR and the crystal grain boundaries GRB in the first metal layer MEL1 may be identified through Electron Backscatter Diffraction (EBSD) on the first metal layer MEL1. The orientation and size of the crystal grains CGR may be visualized and analyzed in the form of a map utilizing EBSD equipment.

The average grain size GS of the crystal grains CGR may be substantially the same as the average size of the plurality of protrusion structures SST. The average grain size GS of the crystal grains CGR may be about 50 nm to about 200 nm. For example, the average grain size GS of the crystal grains CGR may be obtained by measuring the grain sizes of about 100 crystal grains CGR through the above-described analysis method and taking an arithmetic average of them. If (e.g., when) the average grain size GS is greater than about 200 nm, it may be difficult for the metal layers MEL1 and MEL2 of the present disclosure to achieve the desired or suitable mechanical strength. If (e.g., when) the average grain size GS is smaller than about 50 nm, a reverse Hall-Petch effect may occur, which may reduce the mechanical strength of the metal layers MEL1 and MEL2.

The second metal layer MEL2 may also include a plurality of crystal grains, similar to the first metal layer MEL1 described above. The average grain size of the second metal layer MEL2 may be substantially the same as or similar to the average grain size of the first metal layer MEL1.

According to the Hall-Petch equation, the yield strength may be inversely proportional to the average grain size in the metal layer. Because the grain boundaries play a role in preventing or reducing deformation of the metal layer, the mechanical strength of the metal may increase as the size of the crystal grains decreases and the number of grain boundaries increases.

The composite substrate CPS according to one or more embodiments of the present disclosure may have metal layers MEL1 and MEL2 including (e.g., composed of) a plurality of crystal grains CGR and may have a relatively fine average grain size. As a result, the mechanical strength (for example, tensile strength) of the composite substrate CPS may be significantly improved compared to a metal layer having a relatively large average grain size.

Because the composite substrate CPS according to one or more embodiments of the present disclosure has a relatively large mechanical strength, even if (e.g., when) a rolling process is performed after forming a first active material layer ACT1 on the composite substrate CPS, a process defect in which curl occurs on the composite substrate CPS may be prevented or reduced. In addition, because additional processes such as high-strength treatment and/or heat treatment for preventing or reducing curl from occurring during the rolling process may not be provided, the efficiency of the manufacturing process of the rechargeable battery may be improved.

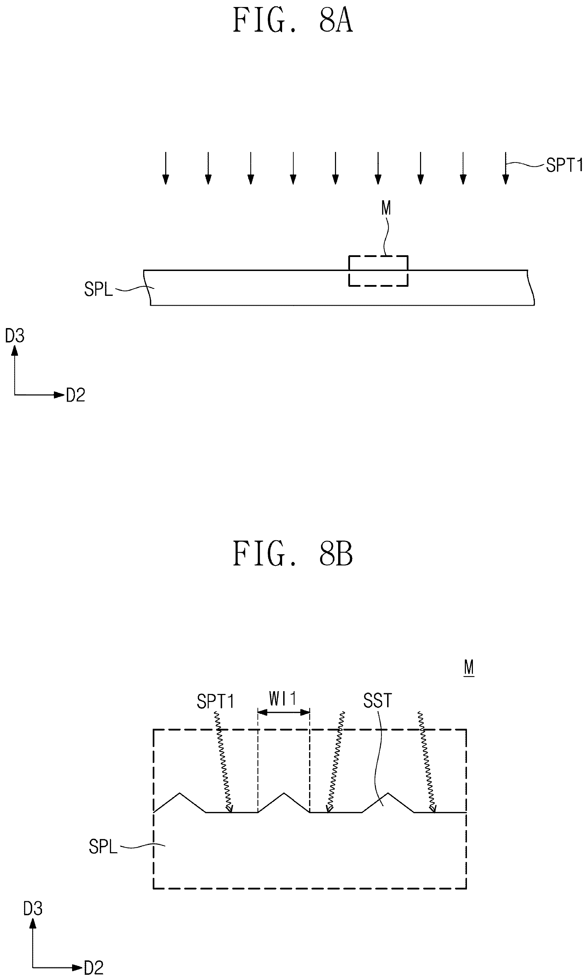

FIGS. 8A, 9A, and 10A are cross-sectional views for explaining a method for manufacturing a composite substrate according to one or more embodiments of the present disclosure. FIGS. 8B, 9B, and 10B are enlarged cross-sectional views showing areas M in FIGS. 8A, 9A and 10A, respectively.

Referring to FIGS. 8A and 8B, a support layer SPL may be provided. The support layer SPL may include a polymer film. For example, the support layer SPL may include a polyethylene film, a polypropylene film, a polyvinylidene chloride film, and/or a multilayer film of a (e.g., any suitable) combination thereof. The support layer SPL may have excellent or suitable ion permeability and excellent or suitable mechanical strength.

A first plasma treatment process SPT1 may be performed on the first surface of the support layer SPL. The first plasma treatment process SPT1 may be performed utilizing at least one selected from among oxygen, argon, nitrogen, and a (e.g., any suitable) combination thereof. The generation power in the first plasma treatment process SPT1 may be at least one selected from among Radio Frequency (RF), Microwave (MW), Direct Current (DC), Pulse, and Low Frequency (LF), and the power density may be about 1 W to about 100 W. The treatment time of the first plasma treatment process SPT1 may be about 10 seconds to about 3 minutes.

Through the first plasma treatment process SPT1, the surface of the support layer SPL may be physically etched by plasma, and protrusion structures SST may be formed. As the protrusion structures SST are formed on the surface of the support layer SPL, the surface roughness of the support layer SPL may increase.

The average size WI1 of the protrusion structures SST formed through the first plasma treatment process SPT1 may be relatively large. For example, the average size WI1 of the protrusion structures SST may be about 10 nm to about 500 nm, or about 50 nm to about 200 nm.

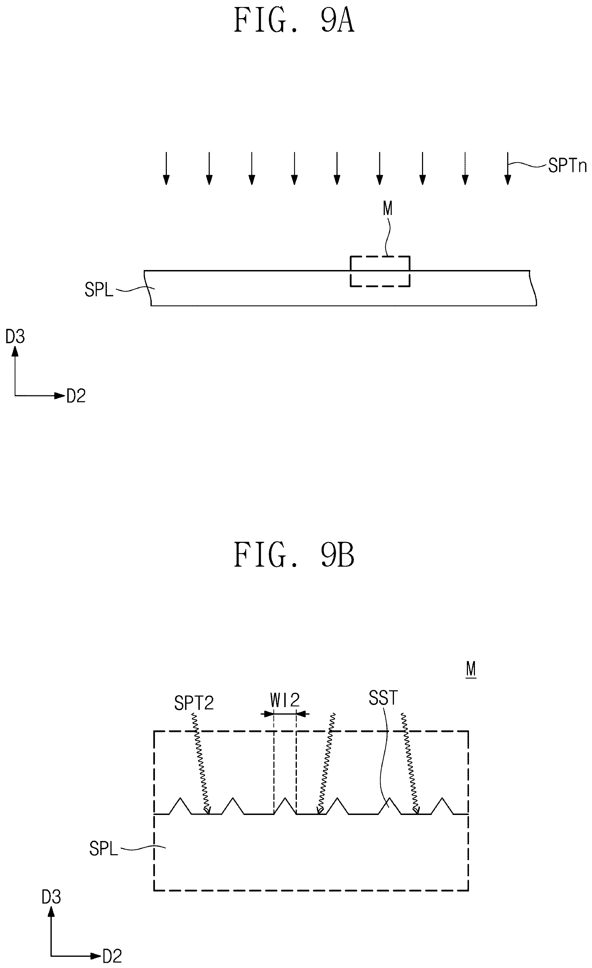

Referring to FIGS. 9A and 9B, an n^{th} plasma treatment process SPTn may be performed on the first surface of the support layer SPL. After the first plasma treatment process SPT1 is performed, a second plasma treatment process SPT2 may be performed on the first surface of the support layer SPL. After the second plasma treatment process SPT2 is performed, a third plasma treatment process SPT3 may be performed. The plasma treatment process may be repeated n times.

n may be an integer between 4 and 20. In one or more embodiments, n may be an integer between 6 and 15. The process conditions of the plasma treatment process that may be repeated n times may be substantially the same as or similar to the first plasma treatment process SPT1 described above.

As the plasma treatment process is repeated n times, the number of protrusion structures SST formed on the surface of the support layer SPL may gradually increase. For example, as the plasma treatment process is repeated n times, the surface roughness of the support layer SPL may gradually increase. As the plasma treatment process is repeated n times, the average size WI2 of the protrusion structures SST may gradually decrease. The average size WI2 of the protrusion structures SST shown in FIG. 9B may be smaller than the average size WI1 of the protrusion structures SST shown in FIG. 8B described above. For example, the average size WI2 of the protrusion structures SST shown in FIG. 9B may be smaller than half of the average size WI1 of the protrusion structures SST shown in FIG. 8B described above.

The average size WI2 of the protrusion structures SST shown in FIG. 9B may be about 50 nm to about 200 nm. In one or more embodiments, the average size WI2 of the protrusion structures SST may be measured through electron microscope analysis of the surface of the support layer SPL. For example, the size (e.g., width) of about 100 protrusion structures SST may be measured, and an arithmetic average of them may be obtained.

The surface roughness (Rrms) of the support layer SPL after the n^{th} plasma treatment process SPTn may be about 5 nm to about 10 nm. For example, the surface roughness may increase by about 0.6 nm each time the plasma treatment process is performed. By determining the number of repetitions of the plasma treatment process, the surface roughness of the support layer SPL may be controlled or selected to a desired or suitable range. By determining the number of repetitions of the plasma treatment process, the average size of the protrusion structures SST of the support layer SPL may be controlled or selected to a desired or suitable range.

The support layer SPL may include a first surface and a second surface that are opposite to each other in the third direction D3. The above-described plasma treatment process may be performed equally on not only the first surface but also the second surface of the support layer SPL. For example, the protrusion structures SST shown in FIG. 9B may be formed on the second surface of the support layer SPL. The surface roughness of the second surface of the support layer SPL may be substantially the same as the surface roughness of the first surface of the support layer SPL.

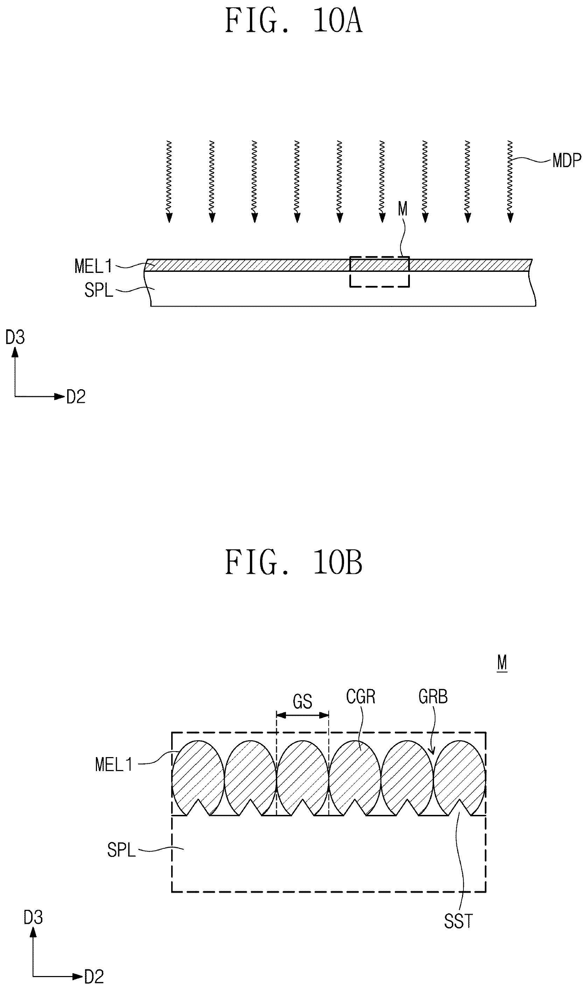

Referring to FIGS. 10A and 10B, a first metal layer MEL1 may be on (e.g., formed on) the first surface of the support layer SPL. The first metal layer MEL1 may be formed utilizing at least one selected from among aluminum, an aluminum alloy, copper, a copper alloy, nickel, a nickel alloy, titanium, a titanium alloy, iron, an iron alloy, silver, and a silver alloy.

The forming of the first metal layer MEL1 may include a deposition process of a metal. In one or more embodiments, the forming of the first metal layer MEL1 may include at least one selected from among a thermal deposition process, a sputtering process, a chemical vapor deposition process, an electron beam deposition process, and a (e.g., any suitable) combination thereof.

In one or more embodiments, the forming of the first metal layer MEL1 may include performing a thermal deposition process (or a vacuum deposition process). The support layer SPL may be placed in a vacuum deposition chamber. The metal wire in the metal evaporation chamber may be melted and evaporated at a temperature of about 1300°C to about 2000°C. The evaporated metal may pass through a cooling system in the vacuum deposition chamber and may be finally deposited on the surface of the support layer SPL.

Referring again to FIG. 10B, while the first metal layer MEL1 may be deposited on the surface of the support layer SPL, a plurality of crystal grains CGR may be grown on the plurality of protrusion structures SST, respectively. Each of the crystal grains CGR may be to grow radially from the top of the protrusion structure SST. The crystal grains CGR may gradually increase in size as while growing. Adjacent crystal grains CGR may be to meet each other and form a grain boundary GRB therebetween. For example, where one crystal grain CGR contacts the other crystal grain CGR may be the grain boundary GRB.

In one or more embodiments, each of the crystal grains CGR may be to grow during the deposition process described above to have an average grain size GS. The average grain size GS may correspond to the average size of the protrusion structures SST formed by the process described above with reference to FIGS. 8A to 9B. For example, by controlling the plasma treatment process performed on the support layer SPL, the average grain size GS of the crystal grains CGR may be controlled or selected to a desired or suitable range.

According to one or more embodiments of the present disclosure, the surface roughness of the support layer SPL may be relatively greatly increased by the repeated plasma treatment described above. By depositing metal on the surface of the support layer SPL with increased roughness, the average grain size GS of the first metal layer MEL1 may be relatively reduced. The first metal layer MEL1 may include (e.g., be composed of) fine-sized crystal grains CGR. As a result, the mechanical strength of the first metal layer MEL1 may be significantly improved.

A metal deposition process may also be performed on the second surface of the support layer SPL to form a second metal layer MEL2. As described above for the first metal layer MEL1, the second metal layer MEL2 may also be formed to include (e.g., be composed of) fine-sized crystal grains CGR.

Referring again to FIG. 6, a method for manufacturing a rechargeable lithium battery according to one or more embodiments of the present disclosure will be described. A composite substrate CPS may be manufactured through the method of FIGS. 7A to 10B described above.

A first active material layer ACT1 may be formed on a coating part of the composite substrate CPS. The first active material layer ACT1 may be formed on each of the first metal layer MEL1 and the second metal layer MEL2. The forming of the first active material layer ACT1 may include applying an active material slurry on the composite substrate CPS and drying the active material slurry.

A rolling process may be performed on the first active material layer ACT1. The rolling process may be performed to improve the rolling density of the first active material layer ACT1. The rolling process may increase the rolling density of the first active material layer ACT1 and decrease the thickness of the first active material layer ACT1.

According to one or more embodiments of the present disclosure, the rolling process may include a roll press. The rolling equipment may include an upper roll arranged on the top of the composite substrate CPS and a lower roll arranged on the bottom of the composite substrate. The upper roll and the lower roll may be configured to press the composite substrate CPS while rotating. In one or more embodiments, the rolling process on the composite substrate CPS may be performed at a pressure of about 5 MPa to about 30 MPa.

During the rolling process, pressure may be selectively applied to the coating part of the composite substrate CPS. The composite substrate CPS according to one or more embodiments of the present disclosure may have relatively high mechanical strength. Therefore, during the rolling process, the composite substrate CPS may be prevented or reduced from being stretched in a certain direction (e.g., one direction). During the rolling process, a process defect that causes curling in the composite substrate CPS may be prevented or reduced.

After the rolling process, an electrode including a second active material layer ACT2 and a metal substrate MES may be provided on the first active material layer ACT1. A separator 30 may be between (e.g., interposed between) the electrode and the first active material layer ACT1. The prepared laminate may be inserted into a pouch or a case. An electrolyte may be injected into the pouch or the case.

Hereinafter, the examples of the present disclosure will be described in more detail. However, the examples are provided only to help understand the present disclosure, and the scope of the present disclosure is not limited thereto.

### Examples 1 to 3 and Comparative Examples 1 to 2: Plasma Treatment of Support Layer

A PET film with a thickness of about 5 µm was prepared. Plasma treatment was performed on the PET film utilizing a capacitively coupled plasma device (FEMTO SCIENCE, Korea). An upper substrate was utilized as ground in Reactive ion etching (RIE) mode, and about 100 W of power was applied to a lower substrate by adjusting the frequency to about 100 kHz. In this case, oxygen gas was supplied at about 20 sccm and plasma treatment was performed under an operating pressure of about 4.5 x 10⁻¹ torr or less. The plasma treatment was performed for about 60 seconds.

**Table 1**

| | Number of plasma treatment repetitions |
|---|---|
| Example 1 | 6 times |
| Example 2 | 10 times |
| Example 3 | 15 times |
| Comparative Example 1 | 5 times |
| Comparative Example 2 | No plasma treatment |

### Manufacture of Composite Substrate

Aluminum was deposited on both (e.g., simultaneously) sides (e.g., opposite sides) of the PET films of Examples 1 to 3 and Comparative Examples 1 and 2, respectively, to form aluminum metal layers. The aluminum deposition process utilized a thermal deposition process. For example, the PET film was placed in a vacuum deposition chamber, and aluminum was melted and evaporated at a temperature of about 1800°C. The deposition process was performed until the thickness of the aluminum metal layer became about 1 µm.

### Evaluation Example 1: Measurement of Average Grain Size of Metal Layer

The grain size of the metal layer of each of the composite substrates of Examples 1 to 3 and Comparative Examples 1 to 2 prepared above was measured utilizing TEM equipment.

For example, a sample of the aluminum metal layer of the composite substrate was collected, and a high-magnification image of the metal layer was captured utilizing TEM equipment. An appropriate or suitable resolution was maintained so that the grain boundaries could be clearly identified, and the magnification of the image was set to about 100,000 times or more.

The grain boundaries in the metal layer were identified by analyzing the TEM image. Grain boundary identification was performed based on the difference in contrast or the difference in the direction of a crystal axis. The grain boundaries were marked utilizing automated image analysis software (for example, ImageJ, or MATLAB).

About 100 crystal grains were randomly selected and the sizes were measured. To measure the size of each crystal grain, the equivalent circle diameter or Feret diameter was calculated. The grain sizes of the crystal grains were arithmetic averaged to obtain an average grain size.

### Evaluation Example 2: Measurement of Mechanical Strength of Composite Substrate

The tensile strength and yield strength were measured for each of the composite substrates of Examples 1 to 3 and Comparative Examples 1 and 2 prepared above.

First, a test specimen was prepared from the composite substrate to meet international standards. The tensile strength of the test specimen was measured utilizing a tensile tester (Universal Testing Machine, UTM). The tensile speed was set to about 5 mm/min for measurement.

The load-displacement data were collected while the specimen was deformed by operating the tensile tester and gradually applying a load. The load was continuously increased until the specimen broke. The tensile strength of the specimen was calculated through the maximum load.

The yield strength was measured as the 0.2% offset yield strength based on a point where the proportional limit ends in a load-displacement curve measured by the tensile tester. For this, a stress-strain curve was created, and a load value corresponding to about 0.2% permanent deformation in the linear section of Young's Modulus was confirmed. The yield strength was calculated through the load value.

The results obtained through Evaluation Examples 1 and 2 are shown in Table 2.

**Table 2**

| | Example 1 | Example 2 | Example 3 | Comparative Example 1 | Comparative Example 2 |
|---|---|---|---|---|---|
| Average grain size (nm) | 125 | 62.5 | 55.6 | 203 | 420 |
| Tensile strength (N/mm²) | 201.2 | 238.2 | 248 | 162.5 | 125.6 |
| Yield strength (N/mm²) | 95.76 | 108.43 | 137.97 | 82.3 | 71.6 |

Referring to Table 2, it may be confirmed that in the composite substrate according to one or more embodiments of the present disclosure, the metal layer has a relatively small grain size. It may be confirmed that both (e.g., simultaneously) the tensile strength and the yield strength increase as the grain size decreases. For example, it may be confirmed that the composite substrate according to the present disclosure has significantly excellent or suitable mechanical strength.

In contrast, in the cases of Comparative Examples 1 and 2 where the plasma treatment was repeated less or omitted completely, it may be confirmed that the grain size of the composite substrate increases to about 200 nm or more. As a result, it may be confirmed that both (e.g., simultaneously) the tensile strength and the yield strength of the composite substrate are lower than those of the composite substrate according to the present embodiment.

The composite substrate for a rechargeable lithium battery according to the present disclosure may have a relatively small average grain size of a metal layer. As a result, the composite substrate of the present disclosure may have a relatively large mechanical strength. The composite substrate of the present disclosure may prevent or reduce a process defect that causes curling during electrode manufacturing.

The method for manufacturing a composite substrate according to the present disclosure may easily or suitably control the average grain size of a metal layer to a desired or suitable range by controlling plasma treatment on a support layer. As a result, a composite substrate having a desired or suitable mechanical strength may be efficiently manufactured.

Overall, a delicately controlled size of grain (e.g., particles) in the composite substrate disclosed in the present disclosure may improve mechanical strength (e.g., the tensile strength and the yield strength), which may prevent or reduce a process defect that causes curling in the substrate.

The battery, a manufacturing apparatus/device thereof, a method for manufacturing the battery, or any other relevant apparatuses/devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

In the present disclosure, each suitable feature of the various embodiments of the disclosure may be combined or combined with each other, partially or entirely, and may be technically interlocked and operated in various suitable ways, and each embodiment may be implemented independently of each other or in conjunction with each other in any suitable manner unless otherwise stated or implied.

Although one or more embodiments of the present disclosure have been described with reference to attached drawings, the present disclosure may be implemented in other specific forms without changing the technical idea or essential features thereof. In addition, techniques for modified practice of one or more embodiments of the present disclosure may also be included. Therefore, the scope of the present disclosure should not be limited to the embodiments described above, but should be determined by claims and equivalents to be described herein.

The present disclosure additionally includes the following numbered Embodiments:
1. A composite substrate for a rechargeable lithium battery, the composite substrate comprising:
   a support layer comprising a polymer;
   a first metal layer on a first surface of the support layer; and
   a second metal layer on a second surface of the support layer,
   wherein
   at least one of the first and second metal layers comprises a plurality of crystal grains, and
   an average grain size of the plurality of crystal grains is about 50 nm to about 200 nm.
2. The composite substrate for a rechargeable lithium battery of Embodiment 1, wherein the at least one of the first and second metal layers comprises a grain boundary formed between adjacent crystal grains among the plurality of crystal grains.
3. The composite substrate for a rechargeable lithium battery of Embodiment 2, wherein the grain boundary is extended in a direction perpendicular to the first surface.
4. The composite substrate for a rechargeable lithium battery of Embodiment 1, wherein
   at least one of the first surface and the second surface comprises a plurality of protrusion structures, and
   an average size of the protrusion structures is about 50 nm to about 200 nm.
5. The composite substrate for a rechargeable lithium battery of Embodiment 1, wherein
   at least one of the first surface and the second surface comprises a plurality of protrusion structures, and
   the plurality of crystal grains are respectively disposed on the plurality of protrusion structures.
6. The composite substrate for a rechargeable lithium battery of Embodiment 1, wherein a surface roughness (Rrms) of at least one of the first surface and the second surface is about 5 nm to about 10 nm.
7. The composite substrate for a rechargeable lithium battery of Embodiment 1, wherein the support layer comprises at least one of a polyethylene film, a polypropylene film, a polyvinylidene chloride film, or a multilayer film of a combination thereof.
8. The composite substrate for a rechargeable lithium battery of Embodiment 1, wherein each of the first and second metal layers comprises at least one of aluminum, an aluminum alloy, copper, a copper alloy, nickel, a nickel alloy, titanium, a titanium alloy, iron, an iron alloy, silver, or a silver alloy.
9. The composite substrate for a rechargeable lithium battery of Embodiment 1, wherein
   at least one of the first surface and the second surface is subjected to plasma treatment n times repeatedly, and
   n is an integer between 6 and 15.
10. A rechargeable lithium battery comprising a positive electrode, a negative electrode, and a separator between the positive electrode and the negative electrode, wherein
   at least one of the positive electrode and the negative electrode comprises:
   the composite substrate according to Embodiment 1; and
   an active material layer on the composite substrate.
11. A method for manufacturing a composite substrate for a rechargeable lithium battery, the method comprising:
   performing plasma treatment on a support layer comprising a polymer;
   forming a plurality of protrusion structures on a surface of the support layer by repeatedly performing the plasma treatment n times; and
   performing a metal deposition process on the surface of the support layer to form a metal layer,
   wherein n is an integer between 6 and 15.
12. The method of Embodiment 11, wherein a process gas of the plasma treatment comprises at least one of oxygen, argon, nitrogen, or a combination thereof.
13. The method of Embodiment 11, wherein a surface roughness (Rrms) of the surface of the support layer on which the plasma treatment was repeatedly performed is about 5 nm to about 10 nm.
14. The method of Embodiment 11, wherein an average size of the protrusion structures is about 50 nm to about 200 nm.
15. The method of Embodiment 11, wherein the forming of the metal layer comprises forming a plurality of crystal grains on the plurality of protrusion structures, respectively.
16. The method of Embodiment 15, wherein an average grain size of the plurality of crystal grains is about 50 nm to about 200 nm.
17. The method of Embodiment 16, wherein the forming of the metal layer further comprises forming a grain boundary between adjacent crystal grains among the plurality of crystal grains.
18. The method of Embodiment 11, wherein the plasma treatment is performed under conditions of about 1 W to about 100 W through at least one of Radio Frequency (RF), Microwave (MW), Direct Current (DC), Pulse, or Low Frequency (LF).
19. The method of Embodiment 11, wherein a treatment time of the plasma treatment is about 10 seconds to about 3 minutes.
20. The method of Embodiment 11, wherein the metal deposition process comprises at least one of a thermal deposition process, a sputtering process, a chemical vapor deposition process, an electron beam deposition process, or a combination thereof.

## Claims

1. A composite substrate for a rechargeable lithium battery (100), the composite substrate comprising:
a support layer comprising a polymer;
a first metal layer on a first surface of the support layer; and
a second metal layer on a second surface of the support layer,
wherein
at least one selected from among the first metal layer and the second metal layer comprises a plurality of crystal grains, and
an average grain size of the plurality of crystal grains is about 50 nm to about 200 nm.

2. The composite substrate as claimed in claim 1, wherein the at least one selected among the first metal layer and the second metal layer comprises a grain boundary between adjacent crystal grains among the plurality of crystal grains.

3. The composite substrate as claimed in claim 2, wherein the grain boundary is extended in a direction normal to the first surface.

4. The composite substrate as claimed in any one of claims 1 to 3, wherein
at least one selected from among the first surface and the second surface comprises a plurality of protrusion structures, and
preferably an average size of the protrusion structures is about 50 nm to about 200 nm.

5. The composite substrate as claimed in any one of claims 1 to 3, wherein
at least one selected from among the first surface and the second surface comprises a plurality of protrusion structures, and
preferably the plurality of crystal grains are respectively on the plurality of protrusion structures.

6. The composite substrate as claimed in any one of claims 1 to 5, wherein a surface roughness (Rrms) of at least one selected from among the first surface and the second surface is about 5 nm to about 10 nm.

7. The composite substrate as claimed in any one of claims 1 to 6, wherein the support layer comprises at least one of a polyethylene film, a polypropylene film, a polyvinylidene chloride film, or a multilayer film of a combination thereof.

8. The composite substrate as claimed in any one of claims 1 to 7, wherein each of the first and second metal layers comprises at least one of aluminum, an aluminum alloy, copper, a copper alloy, nickel, a nickel alloy, titanium, a titanium alloy, iron, an iron alloy, silver, or a silver alloy.

9. The composite substrate as claimed in any one of claims 1 to 8, wherein
at least one selected from among the first surface and the second surface is subjected to plasma treatment n times repeatedly, and
preferably n is an integer between 6 and 15.

10. A rechargeable lithium battery (100) comprising a positive electrode (10), a negative electrode (20), and a separator (30) between the positive electrode (10) and the negative electrode (20), wherein
at least one selected from among the positive electrode (10) and the negative electrode (20) comprises:
the composite substrate according to any one of claims 1 to 9; and
an active material layer on the composite substrate.

11. A method for manufacturing a composite substrate for a rechargeable lithium battery (100), the method comprising:
performing plasma treatment on a support layer comprising a polymer;
forming a plurality of protrusion structures on a surface of the support layer by repeatedly performing the plasma treatment n times; and
performing a metal deposition process on the surface of the support layer to form a metal layer,
wherein n is an integer between 6 and 15.

12. The method as claimed in claim 11, wherein:
a process gas of the plasma treatment comprises at least one of oxygen, argon, nitrogen, or a combination thereof; and/or
a surface roughness (Rrms) of the surface of the support layer on which the plasma treatment was repeatedly performed is about 5 nm to about 10 nm.

13. The method as claimed in any one of claims 11 or 12, wherein an average size of the protrusion structures is about 50 nm to about 200 nm.

14. The method as claimed in any one of claims 11 to 13, wherein the forming of the metal layer comprises forming a plurality of crystal grains on the plurality of protrusion structures, respectively;
preferably wherein an average grain size of the plurality of crystal grains is about 50 nm to about 200 nm.

15. The method as claimed in claim 14, wherein the forming of the metal layer further comprises forming a grain boundary between adjacent crystal grains among the plurality of crystal grains.
